(19) Europäisches Patentamt
European Patent Office
Office européen des brevets

(11) **EP 3 336 956 B1**

(12) **EUROPEAN PATENT SPECIFICATION**

(45) Date of publication and mention
of the grant of the patent:
**30.08.2023 Bulletin 2023/35**

(21) Application number: **16203925.9**

(22) Date of filing: **14.12.2016**

(51) International Patent Classification (IPC):
*H01M 10/48* (2006.01)    *G01R 31/74* (2020.01)
*G01R 31/327* (2006.01)    *G01R 31/36* (2020.01)
*G01N 21/00* (2006.01)    *G01N 21/59* (2006.01)

(52) Cooperative Patent Classification (CPC):
**H01M 10/48; G01R 31/3277; G01R 31/36;
G01R 31/74;** G01N 21/59

(54) **METHOD FOR MONITORING A DISCHARGE DEVICE OF A BATTERY**

VERFAHREN ZUR ÜBERWACHUNG EINER ENTLADUNGSVORRICHTUNG EINER BATTERIE

PROCÉDÉ DE SURVEILLANCE D'UN DISPOSITIF DE DÉCHARGE D'UNE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.06.2018 Bulletin 2018/25**

(73) Proprietors:
• **Robert Bosch GmbH
70442 Stuttgart (DE)**
• **GS Yuasa International Ltd.
Kyoto-shi, Kyoto 601-8520 (JP)**

(72) Inventors:
• **Deromelaere, Gaetan
70806 Kornwestheim (DE)**
• **Klinsmann, Markus
70195 Stuttgart (DE)**
• **Liebenow, Cornelius
70372 Stuttgart (DE)**

(74) Representative: **Isarpatent
Patent- und Rechtsanwälte Barth
Charles Hassa Peckmann & Partner mbB
Postfach 44 01 51
80750 München (DE)**

(56) References cited:
EP-A1- 3 048 693        US-A1- 2004 148 111
US-A1- 2015 115 994    US-A1- 2015 229 011
US-A1- 2015 357 680

## Description

The present invention relates to a method for monitoring an antifuse discharge device of a battery and to a corresponding battery.

EP 3 048 693 A1 discloses a battery pack comprising MOSFET switch elements connected to the terminals over a load and an abnormality diagnostic device, as well as a method for diagnosing an abnormality in a MOSFET switch element.

US 2015/229011 A1 discloses a battery system including at least one battery cell, a thermoelectric element and a thermally controllable device configured to influence a current flow.

In case batteries shall be applied in electric vehicles, the energy density has to be increased. However, with increasing energy density, the effort to maintain the battery in safe state is increasing as well. Therefore, the risk of the battery leaving the safe state is high with high energy density.

In order to avoid uncontrollable energy release due to internal short cuts, which may lead to explosions of the cell, the prior art describes switches to shortcut the battery terminals in order to discharge the cell. The switches establish a high current path in order to allow fast discharging. Such a discharge device is for example disclosed in DE 10 2012 005 979 B4 and will be named antifuse in the further description.

According to the antifuse technology, an activating foil and an isolating foil have to be provided between the two battery terminals. Due to the isolating foil, no current may flow between the two battery terminals. In case the antifuse is activated, a current is caused to flow from a first battery terminal via the activating foil to a second battery terminal, thereby bypassing the isolating foil. The current heats the activating foil which destroys the isolating foil by burning and/or melting. Therefore, a high current can flow from the first battery terminal to the second battery terminal thereby discharge the battery or battery cell.

However, in case a discharge device is provided in a battery adapted for use in a vehicle, is required to monitor the discharge device in order to determine whether the discharge device is damaged. Such damages may occur due to aging of the battery and the discharge device. Particularly in case the discharge device comprises the antifuse technology described above, it is not possible to measure structural parameters of the activating foil that help to determine whether or not the discharge device is damaged due to aging.

Disclosure of the invention

The inventive method as defined in independent claims 1, 2 and 3, respectively allows determining a parameter corresponding to a probability of failure of the discharge device. Particularly, it said probability of failure regards to the rate of success of the isolating foil being destroyed after activating an antifuse discharge device. In general, the probability of failure regards to a rate of success of the discharge device establishing a high-current path between two battery terminals after being activated. It was surprisingly found that such a parameter may depend on only the trend of temperature of the discharge device.

According to the inventive method, a discharge device of a battery is monitored. The discharge device is electrically connected to battery terminals and is adapted to be activated to shortcut the battery terminals. The battery terminals preferably are electrically connected to at least one battery cell. A parameter corresponding to probability of failure of said activating due to aging of the discharge device is determined. This determination is based on the trend of temperature of the discharge device. Said parameter might either be determined by evaluating a behavior of an auxiliary element that undergoes the same temperature trend as the discharge device or by directly measuring said trend. Employing the temperature trend surprisingly allows a very reliable determination of a parameter corresponding to a probability of failure. This parameter is not necessarily a value between 0 and 1 but is preferably comparable with a predefined maximum value that corresponds to a probability of failure that is not acceptable for further use of the discharge device. Therefore, when exceeding the predefined maximum value, the battery or at least the discharge device should be replaced. The inventive method therefore provides a reliable possibility to monitor the discharge device.

The temperature of the discharge device is measured via a temperature sensor. Said temperature sensor preferably is placed directly on a surface of the discharge device. The measured temperature is integrated over time in order to determine the parameter corresponding to probability of failure. A preferable model for calculating aging effects of the discharge device, particularly the activating foil, is based on the Arrhenius-approach. Particularly, a parameter corresponding to the probability of failure due to aging can be calculated from the following equation:

$$\int_{t0}^{t} e^{-b/T(t')} dt'$$

In the above equation, $t$ denotes the present time, $t0$ denotes the time of the first temperature measurement, and b denotes a predefined value. In case a such calculated parameter exceeds a predefined maximum value, the discharge device is preferably regarded as being not reliable enough for further use within a battery.

An auxiliary element is alternatively provided on the discharge device. Particularly, said auxiliary element is provided on a surface of the discharge device. In this way, the auxiliary element undergoes the same temperature trend as the discharge device. Therefore, aging of the auxiliary element can be taken as a parameter for aging of the discharge device. Aging of the auxiliary element is thus determined in order to determine the parameter corresponding to probability of failure. Particularly the auxiliary element is made from a material different from the discharge device, particularly from an activating foil of the discharge device, such that aging of the auxiliary element can be determined in a reliable and simple manner.

The auxiliary element comprises a transparent polymer material. Aging of the transparent polymer material leads to increased haze such that an older transparent polymer material is less see-through than a younger transparent polymer material. The degree of haze is simply and reliably measureable, such that a degree of haze is determined in order to determine the parameter corresponding to probability of failure. The degree of haze particularly can be determined via a photo diode. In a preferred embodiment, a light emitting diode emits a light which is guided through the transparent polymer material and to the photo diode. Based on a proportion of the emitted light energy and the received light energy, the degree of haze can be determined.

The auxiliary element alternatively comprises a vacuum metalized conductive element. The vacuum metalized conductive element will undergo oxidation over time. Therefore, the degree of oxidation is an indication regarding the age of the vacuum metalized conductive element. The vacuum metalized conductive element is preferably provided on the surface of the discharge device. In any way, it is preferred that the discharge device undergoes the same temperature trend as the discharge device. Therefore, the degree of oxidation of the conductive element is determined in order to determine the parameter corresponding to probability of failure. With increasing degree of oxidation, the electric resistance of the element increases. Hence, the degree of oxidation can be determined via electrical resistance measurement.

The invention further regards a battery as defined in independent claims 4, 5 and 6, respectively, the battery comprising at least one battery cell connected to two battery terminals, a discharge device, and a monitoring device. The discharge device is electrically connected to battery terminals and is adapted to be activated to shortcut the battery terminals. Without such activation, the discharge device does not establish an electrical contact between the battery terminals. Particularly, the discharge device is adapted to establish a low-resistance current path allowing the flow of high currents after being activated. Therefore, the discharge device allows transferring the battery or at least one battery cell to a safe state by removing the stored energy. The monitoring device is adapted to determine a parameter corresponding to probability of failure of activating the discharge device due to aging of the discharge device. Said determination of the parameter is based on the trend of temperature of the discharge device. It was surprisingly found that such a simple determination allows providing reliable parameters regarding a probability of failure of the discharge device due to aging. Therefore, the battery or at least the discharge device can be replaced in case said parameter exceeds a predefined maximum value.

The battery comprises at least one temperature sensor for measuring the temperature of the discharge device. The temperature sensor preferably is provided on a surface of the discharge device. Further, the temperature sensor is preferably connected to the monitoring device in order to transmit temperature signals to the monitoring device. The monitoring device is adapted to integrate the measured temperature over time in order to determine the parameter corresponding to probability of failure. Particularly, the parameter corresponding to probability of failure is calculated based on the above mentioned formula.

The battery alternatively comprises an auxiliary element and a sensor. The auxiliary element is particularly provided on the discharge device, preferably on a surface of the discharge device. The sensor is preferably provided on the auxiliary element. Further, the monitoring device is adapted to determine aging of the auxiliary element via the sensor in order to determine the parameter corresponding to probability of failure. Since the auxiliary element undergoes the same temperature trend as the discharge device, aging of the auxiliary element can be taken as parameter for aging of the discharge device. Therefore, the sensor provides reliable data regarding aging of the discharge device without having to measure any parameters of the discharge device.

Particularly, the sensor comprises a photo diode and the auxiliary element comprises a transparent polymer material. The transparent polymer material is preferably provided on a surface of the discharge device. Therefore, the transparent polymer material undergoes the same temperature trend as the discharge device, wherein aging of the auxiliary element can be recognized in an increased degree of haze. Said degree or haze can be determined via the photo diode, which is connected to the monitoring device in order to transmit signals to the monitoring device. Therefore, the monitoring device is adapted to determine a degree of haze of the transparent polymer material via the photo diode in order to determine the parameter corresponding to probability of failure. The battery preferably comprises a light emitting diode emitting light which is guided through the transparent polymer material and to the photo diode. The proportion between the emitted light energy and the received light energy can be employed to determine the degree of haze.

The sensor alternatively comprises an electrical resistance sensor and the auxiliary element comprises a vacuum metalized conductive element. The vacuum metalized conductive element is preferably provided on a surface of the discharge element and therefore undergoes the same temperature trend as the discharge device. This leads to oxidation of the auxiliary element such that aging of the vacuum metalized conductive element can be determined based on the degree of oxidation. An increased degree of oxidation leads to increased electrical resistance of the conductive element. Therefore, the monitoring device is adapted to determine a degree of oxidation of the conductive element via the electrical resistance sensor, in order to determine the parameter corresponding to probability of failure. Hence, no parameter of the discharge device itself has to be measured in order to determine aging of the discharge device.

Description of the drawings

Specific embodiments of the invention will be described together with the attached drawings. In the drawings

Figure 1    is a schematic view of a battery according to a first embodiment of the present invention, and

Figure 2    is a schematic view of the battery according to a second embodiment of the present invention.

Embodiments of the invention

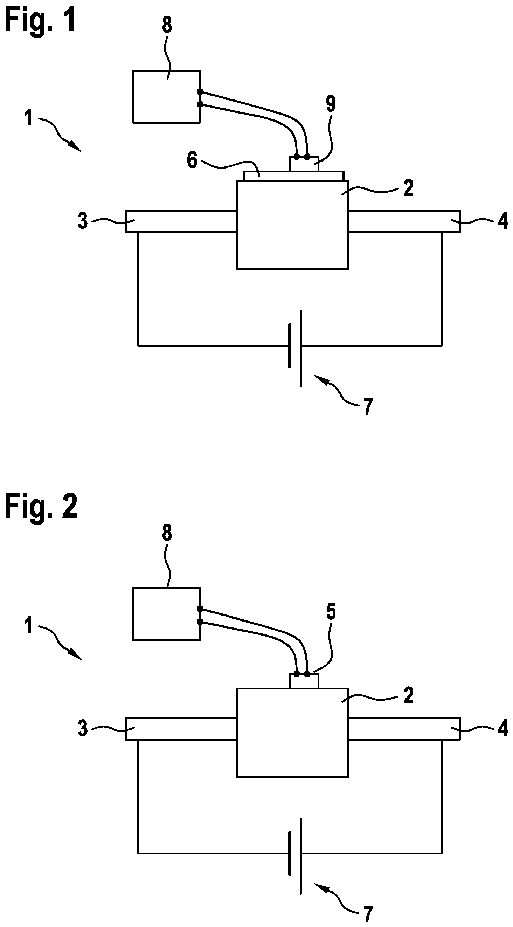

Fig. 1 is a schematic view of a battery 1 according to a first embodiment of the present invention. The battery 1 comprises a first terminal 3 and a second terminal 4, wherein the first terminal 3 and the second terminal 4 are electrically connected to at least one battery cell 7. Via the first terminal 3 and the second terminal 4, electrical power can be delivered to external devices.

In case the battery cell 7 is damaged and an internal shortcut occurs, a temperature increase might be caused which might lead to explosion or burning of the battery cell 7. To avoid such a case, a discharge device 2 is provided. The discharge device 2 is preferably based on the antifuse technology and allows connecting the first terminal 3 and the second terminal 4. After connecting the first terminal 3 and the second terminal 4, a high current can flow to discharge the battery cell 7.

Such a discharge device 2 has to be activated in order to establish the electrical connection between the first terminal 3 and the second terminal 4. However, there might be situations in which the discharge device 2 cannot be activated. This is due to the fact that discharge devices 2, which are based on the antifuse technology, comprise an activating foil which has to destroy an isolating foil in order to establish said electrical connection. However, due to aging of the activating foil, activating might failure.

The battery 1 therefore is provided with a monitoring device 8. The monitoring device 8 is adapted to determine a parameter corresponding to a probability of failure of activating the discharge device 2 due to aging of the discharge device 2. Therefore, the monitoring device 8 might provide a hint to a user of the battery 1 to change the discharge device 2 or the whole battery 1 since the discharge device 2 might be damaged due to aging.

However, it is not possible to measure a structural parameter of the discharge device or the activating foil which would provide reliable information regarding a probability of failure of activating the discharge device. Therefore, the battery 1 according to the first embodiment includes an auxiliary element 6, which is provided on the discharge device 2. The auxiliary element 6 therefore undergoes the same temperature trend as the discharge device 2. It was surprisingly found that only said temperature trend can be employed to gain reliable information regarding a probability of failure of activating the discharge device 2 due to aging.

Since the auxiliary element 6 undergoes the same aging due to the same temperature trend as the discharge device 2, a sensor 9 is provided to measure said aging. The sensor 9 therefore helps to determine aging of the discharge device 2. The sensor 9 particularly measures a structural parameter of the auxiliary element 6, which deteriorates due to aging.

The sensor 9 is connected to the monitoring device 8 in order to transmit signals to the monitoring device 8. The monitoring device 8 is adapted to determine a parameter corresponding to a probability of failure of activating the discharge device 2 due to aging. The monitoring device 8 might be connected to only one sensor 9 or to several sensors 9, wherein each sensor 9 is provided on one discharge device 2. Therefore, the monitoring device 8 might monitor one ore more discharging devices 2.

Particularly, the auxiliary element 6 might comprise a transparent polymer material. Such a material shows aging effects in that a haze is generated such that the transparent polymer material becomes less see-through due to aging. The degree of haze can simply and reliably be determined in case the sensor 9 comprises a photo diode. In a preferred embodiment, the sensor 9 further comprises a light emitting diode or another light source which emits light that is guided through the transparent polymer material and to the photo diode. Based on a proportion of emitted light energy and received light energy, said degree of haze can be determined. The degree of haze is a parameter corresponding to the probability failure of activation the discharge device 2 due to aging.

In another solution, the auxiliary element 6 might comprise a vacuum metalized conductive element. Such a material shows aging effects in oxidation such that an electrical resistance of the conductive element increases. The sensor 9 comprises an electrical resistance sensor for measuring the electrical resistance of the conductive element. Therefore, the monitoring device is adapted to determine a degree of oxidation based on a resistance measurement of the conductive element via the electrical resistance sensor. The degree of oxidation is a parameter corresponding to the probability of failure of activation the discharge device 2 due to aging.

Preferably, the auxiliary element 6 might comprise both, the transparent polymer material and the vacuum metalized conductive element. In the same way, the sensor might comprise both, the photo diode and the electrical resistance sensor.

A second embodiment of the battery 1 is schematically shown in figure 2. The second embodiment is basically identical to the first embodiment, wherein in the second embodiment the battery 1 does not comprise the auxiliary element 6 and the sensor 2. Instead, the battery 1 comprises a temperature sensor 5, which is provided on a surface of the discharge device 2 and which is connected to the monitoring device 8 in order to transmit temperature signals.

The monitoring device 8 is preferably adapted to integrate the temperature of the discharge device 2, which is measured via the temperature sensor 5, over time in order to calculate a parameter corresponding to the probability of failure of activating the discharge device 2 due to aging. Particularly, said parameter is calculated as follows:

$$\int_{t0}^{t} e^{-b/T(t')} dt'$$

In the above equation, $t$ denotes the present time, $t0$ denotes the time of the first temperature measurement, and b denotes a predefined value. In case the such calculated parameter exceeds a predefined maximum value, the discharge device 2 is regarded as being not reliable enough for further use within a battery.

Again, the monitoring device 8 might monitor one or more battery cells 7. Particularly, the monitoring device 8 might receive temperature signals from one or more temperature sensor 5, while each temperature sensor 5 is provided on a single discharge device 2.

The monitoring device 8 therefore executes a method according to an embodiment of the invention. Particularly, the aging influences to the discharging device 2 can be determined without measuring a structural parameter of the discharging device.

**Claims**

1. Method for monitoring an antifuse discharge device (2) of a battery (1), the antifuse discharge device (2) being electrically connected to battery terminals (3, 4) and being adapted to be activated to shortcut the battery terminals (3, 4), wherein a parameter corresponding to probability of failure of said activating due to aging of the antifuse discharge device (2) is determined based on the trend of temperature of the antifuse discharge device (2);

   wherein the temperature of the antifuse discharge device (2) is measured via a temperature sensor (5) and the measured temperature is integrated over time as the parameter corresponding to probability of failure.

2. Method for monitoring an antifuse discharge device (2) of a battery (1), the antifuse discharge device (2) being electrically connected to battery terminals (3, 4) and being adapted to be activated to shortcut the battery terminals (3, 4), wherein a parameter corresponding to probability of failure of said activating due to aging of the antifuse discharge device (2) is determined based on the trend of temperature of the antifuse discharge device (2);

   wherein an auxiliary element (6) is provided on the antifuse discharge device (2) and aging of the auxiliary element (6) is determined in order to determine the parameter corresponding to probability of failure; and
   wherein the auxiliary element (6) comprises a transparent polymer material, wherein a degree of haze of the transparent polymer material is determined via a photo diode, as the parameter corresponding to probability of failure.

3. Method for monitoring an antifuse discharge device (2) of a battery (1), the antifuse discharge device (2) being electrically connected to battery terminals (3, 4) and being adapted to be activated to shortcut the battery terminals (3, 4), wherein a parameter corresponding to probability of failure of said activating due to aging of the antifuse discharge device (2) is determined based on the trend of temperature of the antifuse discharge device (2);

   wherein an auxiliary element (6) is provided on the antifuse discharge device (2) and aging of the auxiliary element (6) is determined in order to determine the parameter corresponding to probability of failure; and
   wherein the auxiliary element (6) comprises a vacuum metalized conductive element, and wherein the degree of oxidation of the conductive element is determined, particularly via electrical resistance measurement, as the parameter corresponding to probability of failure.

4. Battery (1) comprising

   • at least one battery cell (7) connected to two battery terminals (3, 4),
   • an antifuse discharge device (2) being electrically connected to battery terminals (3, 4) and being adapted to be activated to shortcut the battery terminals (3, 4),
   • a monitoring device (8) adapted to determine a parameter corresponding to probability of failure of activating the antifuse discharge device (2) due to aging of the antifuse discharge device (2) based on the trend of temperature of the antifuse discharge device (2),
• at least one temperature sensor (5) for measuring the temperature of the antifuse discharge device (2), wherein the monitoring device (8) is adapted to integrate the measured temperature over time as the parameter corresponding to probability of failure.

5. Battery (1) comprising

• at least one battery cell (7) connected to two battery terminals (3, 4),
• an antifuse discharge device (2) being electrically connected to battery terminals (3, 4) and being adapted to be activated to shortcut the battery terminals (3, 4),
• a monitoring device (8) adapted to determine a parameter corresponding to probability of failure of activating the antifuse discharge device (2) due to aging of the antifuse discharge device (2) based on the trend of temperature of the antifuse discharge device (2),
• an auxiliary element (6) being provided on the antifuse discharge device (2) and a sensor (9), preferably being provided on the auxiliary element (6), wherein the monitoring device (8) is adapted to determine aging of the auxiliary element (6) via the sensor (9) as the parameter corresponding to probability of failure,
• wherein the sensor (9) comprises a photo diode and the auxiliary element (6) comprises a transparent polymer material, wherein the monitoring device (8) is adapted to determine a degree of haze of the transparent polymer material via the photo diode (9), as the parameter corresponding to probability of failure.

6. Battery (1) comprising

• at least one battery cell (7) connected to two battery terminals (3, 4),
• an antifuse discharge device (2) being electrically connected to battery terminals (3, 4) and being adapted to be activated to shortcut the battery terminals (3, 4),
• a monitoring device (8) adapted to determine a parameter corresponding to probability of failure of activating the antifuse discharge device (2) due to aging of the antifuse discharge device (2) based on the trend of temperature of the antifuse discharge device (2),
• an auxiliary element (6) being provided on the antifuse discharge device (2) and a sensor (9), preferably being provided on the auxiliary element (6), wherein the monitoring device (8) is adapted to determine aging of the auxiliary element (6) via the sensor (9) as the parameter corresponding to probability of failure,
• wherein the sensor (9) comprises an electrical resistance sensor and the auxiliary element (6) comprises a vacuum metalized conductive element, and wherein the monitoring device (8) is adapted to determine a degree of oxidation of the conductive element via the electrical resistance sensor (10), as the parameter corresponding to probability of failure.

**Patentansprüche**

1. Verfahren zur Überwachung einer Antifuse-Entladungsvorrichtung (2) einer Batterie (1), wobei die Antifuse-Entladungsvorrichtung (2) mit Batterieterminals (3, 4) elektrisch verbunden und dafür eingerichtet ist, zum Kurzschließen der Batterieterminals (3, 4) aktiviert zu werden, wobei ein Parameter, der einer Ausfallwahrscheinlichkeit des Aktivierens aufgrund von Alterung der Antifuse-Entladungsvorrichtung (2) entspricht, basierend auf dem Temperaturverlauf der Antifuse-Entladungsvorrichtung (2) bestimmt wird;
wobei die Temperatur der Antifuse-Entladungsvorrichtung (2) über einen Temperatursensor (5) gemessen wird und die gemessene Temperatur im Zeitverlauf als der Parameter integriert wird, der der Ausfallwahrscheinlichkeit entspricht.

2. Verfahren zur Überwachung einer Antifuse-Entladungsvorrichtung (2) einer Batterie (1), wobei die Antifuse-Entladungsvorrichtung (2) mit Batterieterminals (3, 4) elektrisch verbunden und dafür eingerichtet ist, zum Kurzschließen der Batterieterminals (3, 4) aktiviert zu werden, wobei ein Parameter, der einer Ausfallwahrscheinlichkeit des Aktivierens aufgrund von Alterung der Antifuse-Entladungsvorrichtung (2) entspricht, basierend auf dem Temperaturverlauf der Antifuse-Entladungsvorrichtung (2) bestimmt wird;

wobei ein Hilfselement (6) an der Antifuse-Entladungsvorrichtung (2) bereitgestellt ist und die Alterung des Hilfselements (6) ermittelt wird, um den Parameter zu bestimmen, der der Ausfallwahrscheinlichkeit entspricht; und
wobei das Hilfselement (6) ein transparentes Polymermaterial umfasst, wobei ein Trübungsgrad des transparenten Polymermaterials über eine Fotodiode als der Parameter bestimmt wird, der der Ausfallwahrscheinlichkeit entspricht.

3. Verfahren zur Überwachung einer Antifuse-Entladungsvorrichtung (2) einer Batterie (1), wobei die Antifuse-Entladungsvorrichtung (2) mit Batterieterminals (3, 4) elektrisch verbunden und dafür eingerichtet ist, zum Kurzschließen der Batterieterminals (3, 4) aktiviert zu werden, wobei ein Parameter, der einer Ausfallwahrscheinlichkeit des Aktivierens aufgrund von Alterung der Antifuse-Entladungsvorrichtung (2) entspricht, basierend auf dem Temperaturverlauf der Antifuse-Entladungsvorrichtung (2) bestimmt wird;

wobei ein Hilfselement (6) an der Antifuse-Entladungsvorrichtung (2) bereitgestellt ist und die Alterung des Hilfselements (6) ermittelt wird, um den Parameter zu bestimmen, der der Ausfallwahrscheinlichkeit entspricht; und
wobei das Hilfselement (6) ein in Vakuum aufgedampftes leitfähiges Element umfasst und wobei der Oxidationsgrad des leitfähigen Elements bestimmt wird, insbesondere über die Messung des elektrischen Widerstands, als der Parameter, der der Ausfallwahrscheinlichkeit entspricht.

4. Batterie (1), umfassend:

• mindestens eine Batteriezelle (7), verbunden mit zwei Batterieterminals (3, 4),
• eine Antifuse-Entladungsvorrichtung (2), die mit Batterieterminals (3, 4) elektrisch verbunden und dafür eingerichtet ist, zum Kurzschließen der Batterieterminals (3, 4) aktiviert zu werden,
• eine Überwachungseinrichtung (8), eingerichtet zum Bestimmen eines Parameters, der der Ausfallwahrscheinlichkeit des Aktivierens der Antifuse-Entladungsvorrichtung (2) aufgrund von Alterung der Antifuse-Entladungsvorrichtung (2) basierend auf dem Temperaturverlauf der Antifuse-Entladungsvorrichtung (2) entspricht,
• mindestens einen Temperatursensor (5) zum Messen der Temperatur der Antifuse-Entladungsvorrichtung (2), wobei die Überwachungseinrichtung (8) eingerichtet ist zum Integrieren der gemessenen Temperatur im Zeitverlauf als den Parameter, der der Ausfallwahrscheinlichkeit entspricht.

5. Batterie (1), umfassend:

• mindestens eine Batteriezelle (7), verbunden mit zwei Batterieterminals (3, 4),
• eine Antifuse-Entladungsvorrichtung (2), die mit Batterieterminals (3, 4) elektrisch verbunden und dafür eingerichtet ist, zum Kurzschließen der Batterieterminals (3, 4) aktiviert zu werden,
• eine Überwachungseinrichtung (8), eingerichtet zum Bestimmen eines Parameters, der der Ausfallwahrscheinlichkeit des Aktivierens der Antifuse-Entladungsvorrichtung (2) aufgrund von Alterung der Antifuse-Entladungsvorrichtung (2) basierend auf dem Temperaturverlauf der Antifuse-Entladungsvorrichtung (2) entspricht,
• ein Hilfselement (6), das an der Antifuse-Entladungsvorrichtung (2) bereitgestellt ist, und einen Sensor (9), vorzugsweise bereitgestellt an dem Hilfselement (6), wobei die Überwachungseinrichtung (8) eingerichtet ist zum Bestimmen der Alterung des Hilfselements (6) über den Sensor (9) als den Parameter, der der Ausfallwahrscheinlichkeit entspricht,
• wobei der Sensor (9) eine Fotodiode umfasst und das Hilfselement (6) ein transparentes Polymermaterial umfasst, wobei die Überwachungseinrichtung (8) eingerichtet ist zum Bestimmen eines Trübungsgrads des transparenten Polymermaterials über die Fotodiode (9) als den Parameter, der der Ausfallwahrscheinlichkeit entspricht.

6. Batterie (1) umfassend

• mindestens eine Batteriezelle (7), verbunden mit zwei Batterieterminals (3, 4),
• eine Antifuse-Entladungsvorrichtung (2), die mit Batterieterminals (3, 4) elektrisch verbunden und dafür eingerichtet ist, zum Kurzschließen der Batterieterminals (3, 4) aktiviert zu werden,
• eine Überwachungseinrichtung (8), eingerichtet zum Bestimmen eines Parameters, der der Ausfallwahrscheinlichkeit des Aktivierens der Antifuse-Entladungsvorrichtung (2) aufgrund von Alterung der Antifuse-Entladungsvorrichtung (2) basierend auf dem Temperaturverlauf der Antifuse-Entladungsvorrichtung (2) entspricht,
• ein Hilfselement (6), das an der Antifuse-Entladungsvorrichtung (2) bereitgestellt ist, und einen Sensor (9), vorzugsweise bereitgestellt an dem Hilfselement (6), wobei die Überwachungseinrichtung (8) eingerichtet ist zum Bestimmen der Alterung des Hilfselements (6) über den Sensor (9) als den Parameter, der der Ausfallwahrscheinlichkeit entspricht,
• wobei der Sensor (9) einen elektrischen Widerstandssensor umfasst und das Hilfselement (6) ein unter Vakuum aufgedampftes leitfähiges Element umfasst und wobei die Überwachungseinrichtung (8) eingerichtet ist zum Bestimmen eines Oxidationsgrads des leitfähigen Elements über den elektrischen Widerstandssensor (10) als den Parameter, der der Ausfallwahrscheinlichkeit entspricht.

**Revendications**

1. Procédé de surveillance d'un dispositif de décharge antifusible (2) d'une batterie (1), le dispositif de décharge antifusible (2) étant connecté électriquement à des bornes de batterie (3, 4) et étant conçu pour être activé afin de court-circuiter les bornes de batterie (3, 4), un paramètre qui correspond à une probabilité de défaillance de ladite activation en raison du vieillissement du dispositif de décharge antifusible (2) étant déterminé sur la base de la tendance de la température du dispositif de décharge antifusible (2) ;
la température du dispositif de décharge antifusible (2) étant mesurée par l'intermédiaire d'un capteur de température (5) et la température mesurée étant intégrée dans le temps en tant que paramètre qui correspond à la probabilité de défaillance.

2. Procédé de surveillance d'un dispositif de décharge antifusible (2) d'une batterie (1), le dispositif de décharge antifusible (2) étant connecté électriquement à des bornes de batterie (3, 4) et étant conçu pour être activé afin de court-circuiter les bornes de batterie (3, 4), un paramètre qui correspond à une probabilité de défaillance de ladite activation en raison du vieillissement du dispositif de décharge antifusible (2) étant déterminé sur la base de la tendance de la température du dispositif de décharge antifusible (2) ;

   un élément auxiliaire (6) étant situé sur le dispositif de décharge antifusible (2) et le vieillissement de l'élément auxiliaire (6) étant déterminé afin de déterminer le paramètre qui correspond à la probabilité de défaillance ; et
   l'élément auxiliaire (6) comprenant un matériau polymère transparent, un degré de trouble du matériau polymère transparent étant déterminé par l'intermédiaire d'une photodiode en tant que paramètre qui correspond à la probabilité de défaillance.

3. Procédé de surveillance d'un dispositif de décharge antifusible (2) d'une batterie (1), le dispositif de décharge antifusible (2) étant connecté électriquement à des bornes de batterie (3, 4) et étant conçu pour être activé afin de court-circuiter les bornes de batterie (3, 4), un paramètre qui correspond à une probabilité de défaillance de ladite activation en raison du vieillissement du dispositif de décharge antifusible (2) étant déterminé sur la base de la tendance de la température du dispositif de décharge antifusible (2) ;

   un élément auxiliaire (6) étant situé sur le dispositif de décharge antifusible (2) et le vieillissement de l'élément auxiliaire (6) étant déterminé afin de déterminer le paramètre qui correspond à la probabilité de défaillance ; et
   l'élément auxiliaire (6) comprenant un élément conducteur métallisé sous vide, et le degré d'oxydation de l'élément conducteur étant déterminé, en particulier par l'intermédiaire d'une mesure de résistance électrique, en tant que paramètre qui correspond à la probabilité de défaillance.

4. Batterie (1) comprenant :

   au moins une cellule de batterie (7) connectée à deux bornes de batterie (3, 4),
   un dispositif de décharge antifusible (2) connecté électriquement à des bornes de batterie (3, 4) et conçu pour être activé afin de court-circuiter les bornes de batterie (3, 4),
   un dispositif de surveillance (8) conçu pour déterminer un paramètre qui correspond à une probabilité de défaillance de l'activation du dispositif de décharge antifusible (2) en raison du vieillissement du dispositif de décharge antifusible (2) sur la base de la tendance de la température du dispositif de décharge antifusible (2),
   au moins un capteur de température (5) pour mesurer la température du dispositif de décharge antifusible (2), le dispositif de surveillance (8) étant conçu pour intégrer la température mesurée dans le temps en tant que paramètre qui correspond à la probabilité de défaillance.

5. Batterie (1) comprenant :

   au moins une cellule de batterie (7) connectée à deux bornes de batterie (3, 4),
   un dispositif de décharge antifusible (2) connecté électriquement à des bornes de batterie (3, 4) et conçu pour être activé afin de court-circuiter les bornes de batterie (3, 4),
   un dispositif de surveillance (8) conçu pour déterminer un paramètre qui correspond à une probabilité de défaillance de l'activation du dispositif de décharge antifusible (2) en raison du vieillissement du dispositif de décharge antifusible (2) sur la base de la tendance de la température du dispositif de décharge antifusible (2),
   un élément auxiliaire (6) situé sur le dispositif de décharge antifusible (2) et un capteur (9), situé de préférence sur l'élément auxiliaire (6), le dispositif de surveillance (8) étant conçu pour déterminer le vieillissement de l'élément auxiliaire (6) par l'intermédiaire du capteur (9) en tant que paramètre qui correspond à la probabilité de défaillance,
   le capteur (9) comprenant une photodiode et l'élément auxiliaire (6) comprenant un matériau polymère transparent, le dispositif de surveillance (8) étant conçu pour déterminer un degré de trouble du matériau polymère transparent par l'intermédiaire de la photodiode (9), en tant que paramètre qui correspond à la probabilité de défaillance.

6. Batterie (1) comprenant :

au moins une cellule de batterie (7) connectée à deux bornes de batterie (3, 4),
un dispositif de décharge antifusible (2) connecté électriquement à des bornes de batterie (3, 4) et conçu pour être activé afin de court-circuiter les bornes de batterie (3, 4),
un dispositif de surveillance (8) conçu pour déterminer un paramètre qui correspond à une probabilité de défaillance de l'activation du dispositif de décharge antifusible (2) en raison du vieillissement du dispositif de décharge antifusible (2) sur la base de la tendance de la température du dispositif de décharge antifusible (2),
un élément auxiliaire (6) situé sur le dispositif de décharge antifusible (2) et un capteur (9), situé de préférence sur l'élément auxiliaire (6), le dispositif de surveillance (8) étant conçu pour déterminer le vieillissement de l'élément auxiliaire (6) par l'intermédiaire du capteur (9) en tant que paramètre qui correspond à la probabilité de défaillance,
le capteur (9) comprenant un capteur de résistance électrique et l'élément auxiliaire (6) comprenant un élément conducteur métallisé sous vide, et le dispositif de surveillance (8) étant conçu pour déterminer un degré d'oxydation de l'élément conducteur par l'intermédiaire du capteur de résistance électrique (10), en tant que paramètre qui correspond à la probabilité de défaillance.

**Fig. 1**

**Fig. 2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3048693 A1
- US 2015229011 A1

- DE 102012005979 B4